# EUROPEAN PATENT APPLICATION

(11) **EP 3 546 972 A1**
(43) Date of publication of application: **02.10.2019**
(21) Application number: 18164987.2
(22) Date of filing: 29.03.2018
(51) Int. Cl.: G01R 33/36, H03F 1/07, H03F 1/02

(54) **INTEGRATED DOHERTY AMPLIFIER AND MAGNETIC RESONANCE IMAGING ANTENNA**

(71) Applicant: Koninklijke Philips N.V., 5656 AE Eindhoven (NL)
(72) Inventor: LEUSSLER, Christoph, 5656 AE Eindhoven (NL); VERNICKEL, Peter, 5656 AE Eindhoven (NL)
(74) Representative: de Haan, Poul Erik

(57) **Abstract**

The invention provides for a radiofrequency system (123, 300, 400, 500, 600, 700, 800, 900, 1000) for a magnetic resonance imaging system (100, 200). The radiofrequency system comprises a first Doherty amplifier (302) and a radio frequency antenna (124). The first Doherty amplifier comprises a first carrier amplifier (308) and a first peaking amplifier (310). The radio frequency antenna is tuned to a magnetic resonance frequency. The first carrier amplifier is connected to the radio frequency antenna at a first connection port (128) of the radio frequency antenna. The first peaking amplifier is connected to the radio frequency antenna at a second connection port (130) of the radio frequency antenna. The first Doherty amplifier is configured for supplying first Radio Frequency power at the magnetic resonance frequency. The radio frequency antenna is configured as a power combiner (126) of the first Doherty amplifier.

## Description

### FIELD OF THE INVENTION

The invention relates to magnetic resonance imaging, in particular to radio frequency systems for magnetic resonance imaging systems.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field.

During an MRI scan, Radio Frequency (RF) pulses generated by an RF amplifier connected to one or more transmitter coils cause a B1+ excitation field. Additionally applied gradient fields and the B1+ excitation field cause perturbations to the effective local magnetic field. RF signals are then emitted by the nuclear spins and detected by one or more receiver coils. Data can be acquired separately by the individual receiver coils. The quality and linearity of the RF amplifier affects the quality of the resulting magnetic resonance images.

International patent application WO 2017055172 A2 discloses a RF power amplifier. The RF power amplifier comprises an RF input distribution network, multiple amplifiers and a signal combining network. The RF input distribution network is configured to divide an input RF signal into a main input signal and an auxiliary input signal. The multiple amplifiers are coupled in parallel to the RF input distribution network and configured to amplify the main and auxiliary input signals respectively by a main amplifier contributing a larger portion of the output power of the RF power amplifier and an auxiliary amplifier contributing a smaller portion of the output power of the RF amplifier. Each of the main and auxiliary amplifiers is selected from the amplifiers according to an impedance Z_{L} of the transmit coil. A loading level of the main amplifier is modulated to alleviate loading mismatch condition of the main amplifier by adjusting current contributions from the main amplifier and the auxiliary amplifier according to the impedance Z_{L} of the transmit coil. The signal combining network is configured to combine the main amplified signal and the auxiliary amplified signal into an output signal to drive the transmit coil.

### SUMMARY OF THE INVENTION

The invention provides for a radio-frequency system, a magnetic resonance magnet assembly, and a magnetic resonance imaging system in the independent claims. Embodiments are given in the dependent claims.

Embodiments of the invention may provide for a simplified and cleaner RF path by using a radio frequency antenna as the combiner for one or more Doherty amplifiers. Using the radio frequency antenna as the combiner may provide for reduced cost, as well as improving the linearity and efficiency of the amplifier.

In one aspect the invention provides for a radio-frequency system for a magnetic resonance imaging system. The radio-frequency system comprises a first Doherty amplifier and a radio-frequency antenna. The first Doherty amplifier comprises a first carrier amplifier and a first peaking amplifier. The term first in first Doherty amplifier is intended as a label. The first Doherty amplifier is a Doherty amplifier. The first in the first carrier amplifier is intended as a label. The first carrier amplifier is a carrier amplifier. The term first in first peaking amplifier is a label. The first peaking amplifier is a peaking amplifier.

The first carrier amplifier is connected to the radio-frequency antenna at a first connection port of the radio-frequency antenna. The second carrier amplifier is connected to the radio-frequency antenna at a second connection port of the radio-frequency antenna. The term first in first radio-frequency power is intended as a label. The first radio-frequency power is radio-frequency power. The first Doherty amplifier is configured for supplying the radio-frequency power to the first connection port and the second connection port in phase. The radio-frequency antenna is configured as a power combiner of the first Doherty amplifier. This embodiment may be beneficial because the use of the radio-frequency antenna as a power combiner eliminates the need for an additional power combiner.

In another embodiment, the radio-frequency antenna is tuned to a magnetic resonance frequency. The first Doherty amplifier is configured for supplying first radio-frequency power at the magnetic resonance frequency. The Doherty amplifier may contain one or radio frequency generators which supply a radio frequency signal that is amplified by the Doherty amplifier.

In another embodiment, the first connection port and the second connection port are in phase at the magnetic resonance frequency.

In another embodiment, the first Doherty amplifier is configured for supplying radio-frequency power to the first connection port and the second connection port in phase.

In another embodiment, the first carrier amplifier and the first peaking amplifier are driven by a single digitally controlled transmitter. In some examples a quad hybrid is used to split a signal, or there may be a digitally controlled transmitter for both the first carrier amplifier and the first peaking amplifier.

In another embodiment, the first carrier amplifier is connected to the first connection port via a first matching network. The first peaking amplifier is connected to the second connection port via a second matching network. This embodiment may be beneficial because it may provide for the radio-frequency antenna to more stably function as the power combiner of the first Doherty amplifier.

In another embodiment, the first carrier amplifier is driven by a first digitally controlled transmitter. The first peaking amplifier is driven by a second digitally controlled transmitter. The term first in first digitally controlled transmitter is used as a label. The first digitally controlled transmitter is a digitally controlled transmitter. The term second in second digitally controlled transmitter is also a label. The second digitally controlled transmitter is a digitally controlled transmitter. A digitally controlled transmitter as used herein is a transmitter which may be used to generate a radio-frequency signal of a given frequency and a given phase. The frequency and/or the phase may be digitally controlled.

In another embodiment, the radio-frequency system comprises a first magnetic field sensor for measuring first magnetic field data descriptive of a first B 1 magnetic field generated by the first Doherty amplifier and the radio-frequency coil. The term first in first magnetic field sensor, first magnetic field data, and first B1 magnetic field are intended as labels. The first magnetic field sensor is a magnetic field sensor. The first magnetic field data is magnetic field data. The first B1 magnetic field is a B1 magnetic field. The radio-frequency system further comprises a first controller configured for controlling the first digitally controlled transmitter. The controller is configured for receiving the first magnetic field data from the first magnetic field sensor. The Controller may be digital and input signals are controlled in digital domain via software or machine executable instructions. The controller may comprise an analog to digital converter for the sensor data, a "brain" or processor to process the demand vs. Actual comparison, and a digital to analog DA connecting to the analogue input of the Doherty amp(s) to control them.

The controller is further configured to adjust the output of the first digitally controlled transmitter and the second digitally controlled transmitter using the first magnetic field data to linearize the first Doherty amplifier. This embodiment may be beneficial because it may provide for increasing the linearity of the first Doherty amplifier.

In another embodiment, the first carrier amplifier is a class AB amplifier. The first peaking amplifier is a class C amplifier.

In other embodiments there may be a second, third, and/or fourth Doherty amplifier connected to the radio-frequency antenna. The radio-frequency antenna may be used as the power combiner for all of these additional Doherty amplifiers. The features of the additional Doherty amplifiers may be identical with the first Doherty amplifier as described above.

In another embodiment, the radio-frequency system further comprises a second Doherty amplifier. The second Doherty amplifier comprises a second carrier amplifier and a second peaking amplifier. The second carrier amplifier is connected to the radio-frequency antenna at a third connection port of the radio-frequency antenna. The second carrier amplifier is connected to the radio-frequency antenna at a fourth connection port of the radio-frequency antenna. The term second in second Doherty amplifier is intended as a label. The second Doherty amplifier is a Doherty amplifier. The term second in second carrier amplifier is intended as a label. The second carrier amplifier is a carrier amplifier. The term second in second peaking amplifier is intended as a label. The second peaking amplifier is a peaking amplifier.

The second Doherty amplifier is configured for supplying a second radio-frequency power at the magnetic resonance frequency. The second Doherty amplifier is configured for supplying the second radio-frequency power to the third connection port in quadrature to the first radio-frequency power supplied to the first connection port and the second connection port. The radio-frequency antenna is further configured as a power combiner of the second Doherty amplifier. This embodiment may be beneficial because two separate Doherty amplifiers may be combined such that they use the same radio-frequency antenna as their combiner.

In another embodiment, the second Doherty amplifier is configured for supplying the second radio-frequency power to the third connection port and the fourth connection port in phase.

In another embodiment the second Doherty amplifier is configured for supplying the second radio-frequency power to the fourth connection port in quadrature to the first radio-frequency power supplied to the first connection port and the second connection port.

In another embodiment, the second carrier amplifier is connected to the third connection port via a third matching network. The second peaking amplifier is connected to the fourth connection port via a fourth matching network. The term third in third matching network is intended as a label. The third matching network is a matching network. The term fourth in fourth matching network is also intended as a label. The fourth matching network is a matching network.

In another embodiment, the first connection port and the second connection port at in phase at the magnetic resonance frequency. At the magnetic resonance frequency the third connection port and the fourth connection port are in phase. At the magnetic resonance frequency the third connection port is a quadrature to the first connection port and the second connection port.

In another embodiment, at the magnetic resonance frequency the fourth connection port is at quadrature to the first connection port and the second connection port.

In another embodiment, the second carrier amplifier is driven by a third digitally controlled transmitter. The second peaking amplifier is driven by a fourth digitally controlled transmitter. The term third in third digitally controlled transmitter is a label. The third digitally controlled transmitter is a digitally controlled transmitter. The term fourth in fourth digitally controlled transmitter is a label. The fourth digitally controlled transmitter is a digitally controlled transmitter.

Using separate digitally controlled transmitters for each of the amplifiers may have the benefit of being able to finely adjust the amplitude and phase independently to make them more linear.

In another embodiment, the radio-frequency system comprises a second magnetic field sensor for measuring a second magnetic field data descriptive of a second B1 magnetic field generated by the second Doherty amplifier and the radio-frequency coil. The term second in second magnetic field sensor is a label. The second magnetic field sensor is a magnetic field sensor. The term second in second magnetic field data is a label. The second magnetic field data is magnetic field data. The term second in second B1 magnetic field is a label also. The second B1 magnetic field is a B1 magnetic field.

The radio-frequency system further comprises a second controller configured for controlling the third digitally controlled transmitter and the fourth digitally controlled transmitter. The term second in second controller is a label. The second controller is a controller. In some examples the second controller and the first controller are identical.

The second controller is further configured for receiving the second magnetic field data from the second magnetic field sensor. The second controller is further configured to adjust the output of the third digitally controlled transmitter and the fourth digitally controlled transmitter using the second magnetic field data to linearize the second Doherty amplifier.

A magnetic field sensor as used herein encompasses a sensor which may be used to directly measure the magnetic field or a quantity related to the magnetic field. For example the magnetic field sensor might measure the current or voltage at a particular position or portion of the radio-frequency antenna and from this the magnetic field can be inferred.

In another embodiment, the second carrier amplifier is a class AB amplifier. The second peaking amplifier is a class C amplifier.

In another embodiment, the radio-frequency coil is a birdcage coil.

In another embodiment, the radio-frequency coil is a TEM coil.

In another embodiment, the radio-frequency coil is an array of cylindrical birdcage coils.

In another embodiment, the radio-frequency coil is a surface loop coil.

In another embodiment, the radio-frequency coil is a solenoidal coil.

In another embodiment, the first Doherty amplifier is a three-way Doherty amplifier. The first Doherty amplifier further comprises an additional peaking amplifier. The additional peaking amplifier may for example be an additional class C amplifier. The first additional peaking amplifier is connected to the radio-frequency antenna at a first additional connection port of the radio-frequency antenna. The first Doherty amplifier is configured for supplying the radio-frequency power to the first connection port, the second connection port, and the first additional connection port in phase.

In another aspect, the invention provides for a magnetic resonance magnet assembly. The magnetic resonance magnet assembly comprises a main magnet for generating a main magnetic field and a radio-frequency system according to an embodiment. For example the radio-frequency system may be detachably attached to the main magnet.

In another aspect, the invention provides for a magnetic resonance imaging system for acquiring magnetic resonance data from an imaging zone. The magnetic resonance imaging system comprises a magnetic resonance magnet assembly.

It is understood that one or more of the aforementioned embodiments of the invention may be combined as long as the combined embodiments are not mutually exclusive.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection maybe made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

Magnetic Resonance (MR) data is defined herein as being the recorded measurements of radio frequency signals emitted by atomic spins using the antenna of a Magnetic resonance apparatus during a magnetic resonance imaging scan. A Magnetic Resonance Imaging (MRI) image or MR image is defined herein as being the reconstructed two or three dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a magnetic resonance imaging system;
Fig. 2 illustrates a further example of a magnetic resonance imaging system;
Fig. 3 illustrates an example of a radio frequency system for a magnetic resonance imaging system;
Fig. 4 illustrates a further example of a radio frequency system for a magnetic resonance imaging system;
Fig. 5 illustrates a further example of a radio frequency system for a magnetic resonance imaging system;
Fig. 6 illustrates a further example of a radio frequency system for a magnetic resonance imaging system;
Fig. 7 illustrates a further example of a radio frequency system for a magnetic resonance imaging system;
Fig. 8 illustrates a further example of a radio frequency system for a magnetic resonance imaging system;
Fig. 9 illustrates a further example of a radio frequency system for a magnetic resonance imaging system;
Fig. 10 illustrates a further example of a radio frequency system for a magnetic resonance imaging system; and
Fig. 11 shows a block diagram which illustrates the function of a control system for the radio frequency system of Figs. 9 and 10.

### DETAILED DESCRIPTION OF THE EMBODIMENTS

Like numbered elements in these figures are either equivalent elements or perform the same function. Elements which have been discussed previously will not necessarily be discussed in later figures if the function is equivalent.

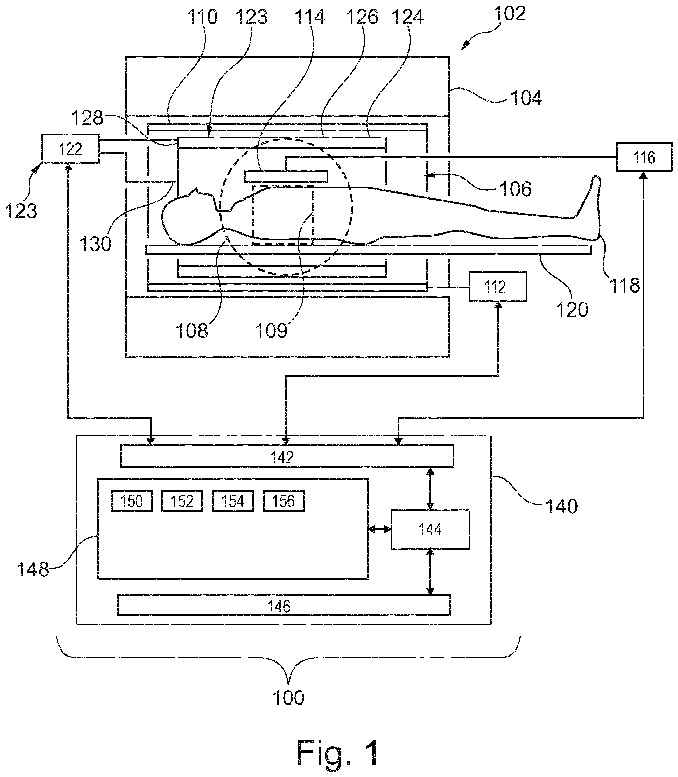

Fig. 1 illustrates an example of a magnetic resonance imaging system 100. The magnetic resonance imaging system 100 is shown as comprising a magnet assembly 102. The magnet assembly 102 comprises a magnet or main magnet 104 and a radio-frequency system 123. The radio-frequency system 123 comprises a Doherty amplifier 122. The radio-frequency system also comprises a radio-frequency antenna 124. The radio-frequency antenna 124 also functions as the power combiner 126 of the Doherty amplifier 122. The radio-frequency antenna 124 can therefore be considered to be part of the Doherty amplifier 122. The Doherty amplifier 122 and/or the radio-frequency antenna 124 may be attached to the magnet 104. In this example the radio-frequency antenna 124 is shown as being a body coil. However, in other examples the radio-frequency antenna 124 may take different forms. For example it could be a birdcage coil, a TEM coil, an array of cylindrical birdcage coils, a surface loop coil or even a solenoidal coil.

The magnet 104 is a superconducting cylindrical type magnet with a bore 106 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore 106 of the cylindrical magnet 104 there is an imaging zone 108 where the magnetic field is strong and uniform enough to perform magnetic resonance imaging. A region of interest 109 is shown within the imaging zone 108. The magnetic resonance data that is acquired typically acquried for the region of interest. A subject 118 is shown as being supported by a subject support 120 such that at least a portion of the subject 118 is within the imaging zone 108 and the region of interest 109.

Within the bore 106 of the magnet there is also a set of magnetic field gradient coils 110 which is used for acquisition of preliminary magnetic resonance data to spatially encode magnetic spins within the imaging zone 108 of the magnet 104. The magnetic field gradient coils 110 connected to a magnetic field gradient coil power supply 112. The magnetic field gradient coils 110 are intended to be representative. Typically magnetic field gradient coils 110 contain three separate sets of coils for spatially encoding in three orthogonal spatial directions. A magnetic field gradient power supply supplies current to the magnetic field gradient coils. The current supplied to the magnetic field gradient coils 110 is controlled as a function of time and may be ramped or pulsed.

The radio frequency antenna 124 is a radio-frequency coil that may be used for manipulating the orientations of magnetic spins within the imaging zone 108. Adjacent to the subject 118 in the imaging zone is a receive coil 114 for receiving radio transmissions from spins also within the imaging zone 108. The receive coil 114 may contain multiple coil elements. The receive coil 114 may also be referred to as a channel or antenna. The receive coil 114 is connected to a radio frequency reciever 116.

In some examples the radio frquency reciver may also be a transciever. In this case, the recieve coil 114 may also have multiple receive/transmit elements and the radio frequency transceiver 116 may have multiple receive/transmit channels. For example if a parallel imaging technique such as SENSE is performed, the receive coil 114 could have multiple coil elements.

The receiver 116, the gradient controller 112, and the Doherty amplifier 122 are shown as being connected to a hardware interface 142 of a computer system 140. The computer system further comprises a processor 144 that is in communication with the hardware interface 142, a memory 148, and a user interface 146. The memory 148 may be any combination of memory which is accessible to the processor 144. This may include such things as main memory, cached memory, and also non-volatile memory such as flash RAM, hard drives, or other storage devices. In some examples the memory 148 may be considered to be a non-transitory computer-readable medium.

The memory 148 is shown as containing machine-executable instructions 150. The machine-executable instructions 150 enable the processor 142 to control the operation and function of the magnetic resonance imaging system 100. The machine-executable instructions 150 may also enable the processor 144 to perform various data analysis and calculation functions. The computer memory 148 is further shown as containing pulse sequence commands 152. The pulse sequence commands are configured for controlling the magnetic resonance imaging system 100 to acquire magnetic resonance data from the subject 154 according to a quantitative magnetic resonance imaging protocol for quantitatively determining a relaxation time.

The memory 148 is further shown as containing magnetic resonance data 154 that was acquired with the pulse sequence commands 152. The memory 148 is further shown as containing a magnetic resonance image 156 that was reconstructed from the magnetic resonance data 154.

In Fig. 1 a single Doherty amplifier 122 is shown. The magnetic resonance imaging system 100 in Fig. 1 may be modified by attaching a second, third or even fourth Doherty amplifier 122 to the radio-frequency antenna 124.

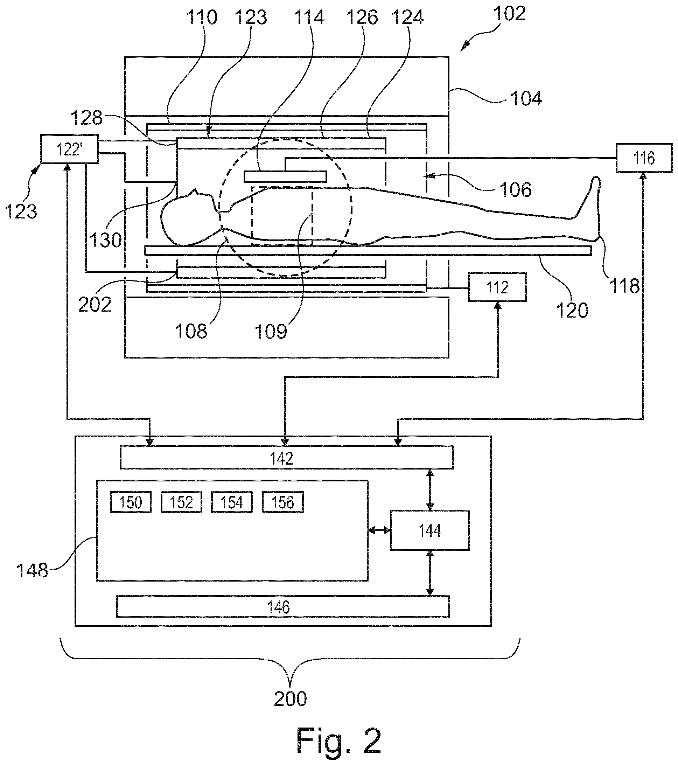

Fig. 2 shows an additional example of a magnetic resonance imaging system 200. The magnetic resonance imaging system 200 in Fig. 2 is similar to the magnetic resonance imaging system 100 in Fig. 1. In Fig. 2 the Doherty amplifier has been replaced with a three-way Doherty amplifier 122'. The three-way Doherty amplifier comprises a first additional peaking amplifier. The additional peaking amplifier is connected to the radio-frequency antenna 124 using an additional connection port 202.

In Fig. 2 a single three-way Doherty amplifier 122' is shown. In other embodiments a second, third, or even fourth three-way Doherty amplifier may be additionally added to the radio-frequency system 123.

Embodiments may provide for an MRI RF transmit chain (radio frequency system) with a near magnet Doherty RF amplifier module that features in some examples the MR system body coil as a RF power combiner. Each individual port of the body coil is driven by either class AB or class C MRI RF amplifier

In some examples a 4 port RF body coil directly combines Doherty RF amplifier at the front or/and back ring.

Examples may provides high efficiency, high linearity and cost reduction compared to conventional MRI RF chain.

The overall aim of the transmit RF chain is to generate a desired spin excitation in a minimum period of time, while complying with technological and biological limits. The RF transmit chain consist of the RF waveform generator, analogue S/R switches and the MRI antenna. The waveform generator of a MRI system consists of DA-converters and several high power RF amplifiers arranged in series and parallel, to achieve the desired drive of the MRI coil in the order of several 10kW. The RF amplifier is preferably close or at the magnet to reduce cable losses. Additionally, the RF coil can be used as a RF power combiner for near magnet RF amplifiers.

Multi-channel transmission may be required for RF shimming and for equally distributing the RF power in the coil. MRI requires a RF transmit chain special type and performance with RF pulse power capability in the order of 10kW, within the order of 1ms:

Certain MRI sequences cannot be accelerated due to hardware limits or due to biological limits like tissue heating. For certain parameters, there are fix absolute limits, such as maximum Peak power or low efficiency of the amplifier. Other are somewhat flexible and depend or on the temporal evolution of the RF waveforms, such as the maximum available short term average RF power, which depends on the pulse shape and the RF power applied in the close past.

The Doherty amplifier may be used for maximizing the power amplifier efficiency, while simultaneously maintaining amplifier linearity for signals with high peak-to-average power ratios.

For conventional RF amplifiers, efficiency is dependent on the output power and increases with the increased output power. Hence, the highest efficiency is obtained at saturation region where a high nonlinearity occurs. In the back-off region since the output power is low, efficiency is also very low but the amplifier behaves substantially linear. In conventional amplifiers, the design is made as a compromise of linearity and efficiency.

Examples may provide for a near MRI magnet RF amplifier based on the Doherty principle using directly the RF body coil as a RF power combiner.
This overcomes the linearity vs. efficiency issue of conventional amplifiers as well as the cost penalty in case the Doherty principle is realized with more complex hardware (e.g. additional dedicated power combiners for combining the submodules outside the body coil.)

To maintain high efficiency and high linearity together is a challenge for the MRI RF chain, which uses a RF amplifier directly on the magnet. MRI RF chains may have one or more of the following technical challenges:
- The amplifier needs to be driven also in the nonlinear regime
- The highest efficiency is obtained at saturation region
- Low efficiency in low RF power regime
- Crosstalk of the individual RF amplifier outputs to each other depending of the load.
- The RF chain need to be robust for Multiband Application
- Short term high duty cycle RF pulses of about 100ms
- Variable loading,
- Superior linearity, stability
- Channel coupling in multi-channel TX systems
- Robustness for multi slice applications

Examples may provide hardware and/or software required to realize a MRI system with optimized RF transmit chain and RF amplifier directly at the MRI magnet.

Examples may provide for an MRI RF transmit chain with a near magnet Doherty RF amplifier module that features the MR system body coil as a RF power combiner. Each individual port of the body coil is driven by either class AB (highly linear but inefficient) or class C (highly efficient but nonlinear) MRI RF amplifier

Normally the power of class AB and class C modules need to be combined in a dedicated combiner stage. However, the 4 port RF body coils that are available allows to directly combine Doherty RF amplifier modules at the front or/and back ring.

Examples may provide for a transmit RF chain design provides high efficiency, high linearity and cost reduction compared to conventional MRI RF chain.

Use of digital RF chain using Body Coil combination of Doherty RF amplifiers. The feeding, balancing and parameter setting of the individual RF amplifiers is controlled by a digital feedback loop and a software module.

In some examples, the Class C amplifier is used to "top up" the signal when the Class AB amplifier reaches the compression point (i.e. its output power reaches the nonlinear region). Below a certain point, the Class AB amplifier runs the show. The Class AB stage is referred to as the "carrier" amplifier herein. When the signal is near its average level, the Class-C stage is not operating, yet the carrier amplifier is operating near its compression point, hence operating at its most efficient level (ideally near 78% efficiency). Once the compression point limit is exceeded and even more RF power is required, the Class C stage starts to operate and "tops-up" the now compressing Class AB stage. The Class C stage is referred to as the "peaking amplifier" herein.

The carrier amplifier may operate in the linear region at low power levels and saturates (nonlinear region) at high power levels. Class-AB or Class-B amplifiers are used as carrier amplifiers. The efficiency at low power region is determined by the efficiency of this amplifier. The peaking amplifier is not active at low power levels and its transistor is cut-off. At high power levels or at the peaks of the modulated input signal it turns on and compensates the nonlinearity of the carrier amplifier, hence. in sum a linear amplified power is obtained. This amplifier should be biased as Class-C to meet the required specifications both at low power and at high power region.

Preferably, the two submodules should operate without affecting each other's performance. Thus the output of the class C amplifier could have a high impedance value when it is in cut-off, otherwise the power delivered by the carrier amplifier may flow through this branch.

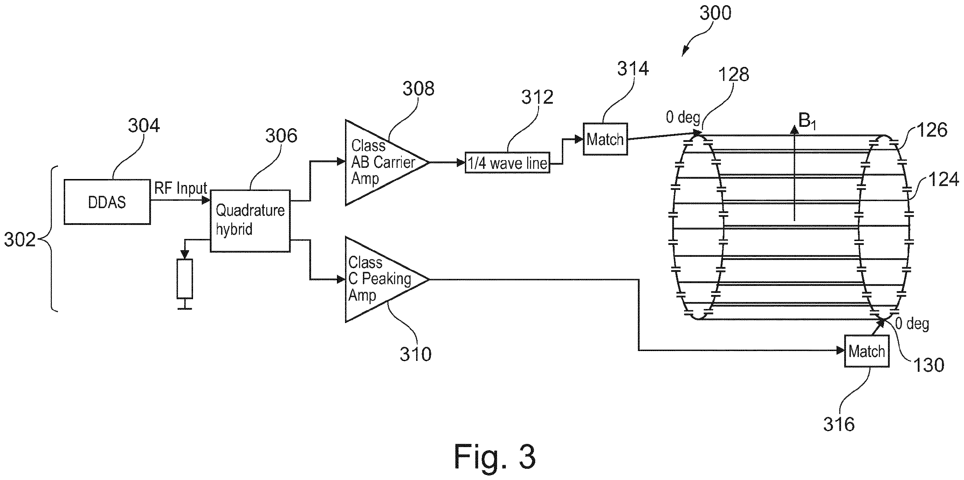

Fig. 3 shows a typical birdcage resonator body coil driven by a Doherty amplifier. The ports arranged in the shown way are highly coupled. Power fed into the ports gets combined in the coil and contributes to one of the linearly polarized modes of the body coil. The input for the sub modules is generated by the DA converter in the DDAS (digital data acquisition system), and split and phase aligned by a Quadrature hybrid.

Fig. 3 illustrates a further example of a radio-frequency system 300. The radio-frequency system comprises a single first Doherty amplifier 302. In this example there is a first digitally controlled transmitter 304 that supplies RF power to a quadrature hybrid 306. This has been split into two signals. The first signal goes to the first carrier amplifier 308 and the second signal goes to the first peaking amplifier 310. The first carrier amplifier 308 is then connected via a quarter wave line 312 delay to a first matching network 314. The first peaking amplifier 310 is connected to the second matching network 316. The first matching network 314 and the second matching network 316 then are both connected to the power combiner 126. In this example the power combiner 126 is also the radio-frequency antenna 124. In this example the radio-frequency antenna 124 is a birdcage coil such as would be used for a body coil. The inputs are connected on opposite rings of the birdcage coil and are connected such that they are connected at the same phase.

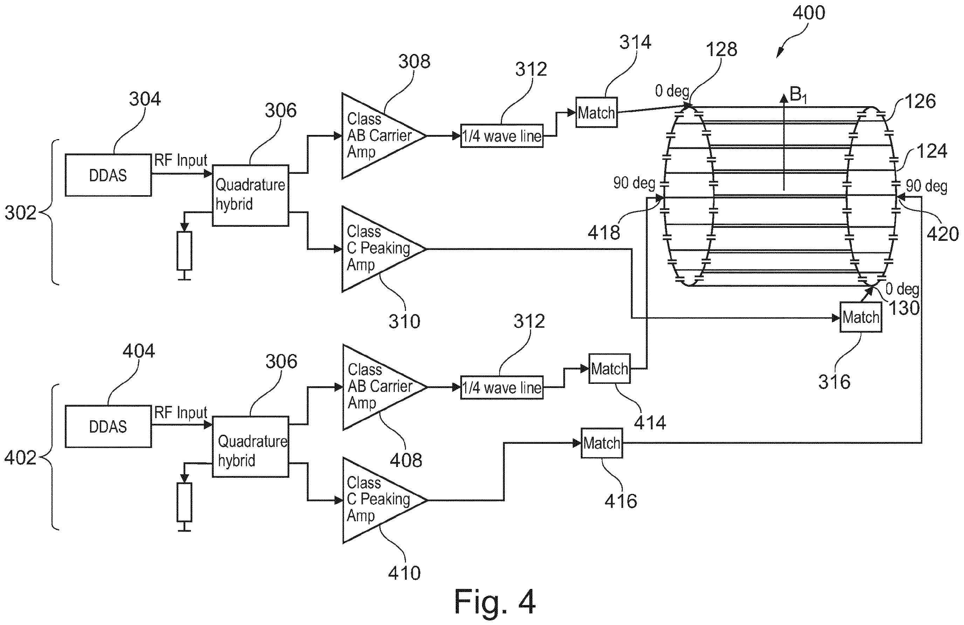

Fig. 4 shows a typical birdcage resonator body coil driven by two Doherty amplifier. The 90deg ports in itself are highly coupled as well but decoupled from the 0deg pair. This allows to use the two independently driven Doherty amplifiers for generating the desired quadrature mode excitation (two liner modes with a 90degree phase shift) or any other signal combination demanded by RF shimming.

Fig. 4 shows a further example of a radio-frequency system 400. The radio-frequency system 400 of Fig. 4 is similar to the radio-frequency system 300 of Fig. 3. There is however an additional second Doherty amplifier 402 in Fig. 4. The second Doherty amplifier 402 comprises a third digitally controlled transmitter 404 that is connected to a quadrature hybrid 306. The RF input from the second Doherty amplifier 402 is split by the quadrature hybrid 306 into a first signal which goes to a second carrier amplifier 408 and a second signal which goes to a second peaking amplifier 410.

The second carrier amplifier 408 is connected to a third match network 414 via a quarter wave line delay 312. The second peaking amplifier 410 is connected to a fourth matching network 416. The third matching network 414 is connected to a third connection port 418 and the fourth matching network 416 is connected to a fourth connection port 420. The third connection port and the fourth connection port are arranged such that they are at the same phase. The third connection port and the fourth connection port are on opposite rings of the birdcage coil 124. The third connection port 418 and fourth connection port 420 are a quadrature to the first input port 128 and the second input port 130. The two Doherty amplifiers 302 and 402 therefore represent input to two independent modes of the birdcage coil 124.

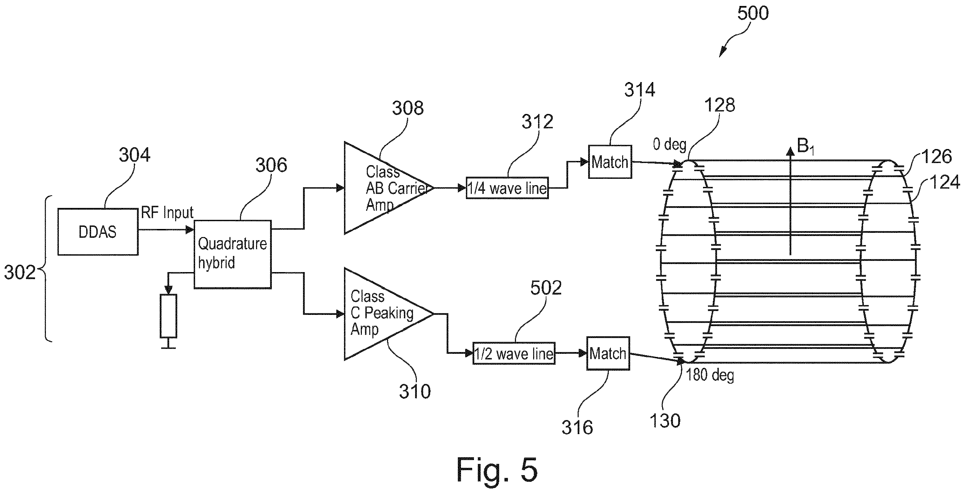

Next to the 0deg port allocation points shown in Figs. 3 and 4 other highly coupled locations can be found in a resonant birdcage coil. Fig. 5 shows an example where the coil gets driven in only one ring instead of two. Here, the operating phase has to be considered since the opposing port requires a 180deg drive. Consequently, wave lines at the outputs of the modules are adapted. Fig.5 shows a Doherty RF amplifier with direct 4 port RF body coil combination at the front. A 180 deg phase shift is required to drive the body coil, which is realized using 180 deg phase shifter.

Fig. 5 shows a further example of a radio-frequency system 500. The radio-frequency system 500 of Fig. 5 is similar to the radio-frequency system 300 of Fig. 3 with several differences. Up to the first carrier amplifier and the first peaking amplifier 310 the implementation in Fig. 5 is identical to Fig. 3. The carrier amplifier 308 is connected to the first matching network 314 again via a quarter wave line delay 312. The first matching network 314 is again connected to a first input port 128. The first peaking amplifier 310 is connected to a one half a wave line delay 502 and then to the second matching network 316. The second matching network 316 is again connected to a second input port 130 but the second input port 130 is located in a different position than was located in Fig. 3. In the example in Fig. 5 both inputs ports 128, 130 are located on the same ring of the birdcage coil 124. They are located at opposite ends of the ring and one input is 180° in phase from the other. The addition of the quarter wave line delay 502 allows a connection as shown in Fig. 5.

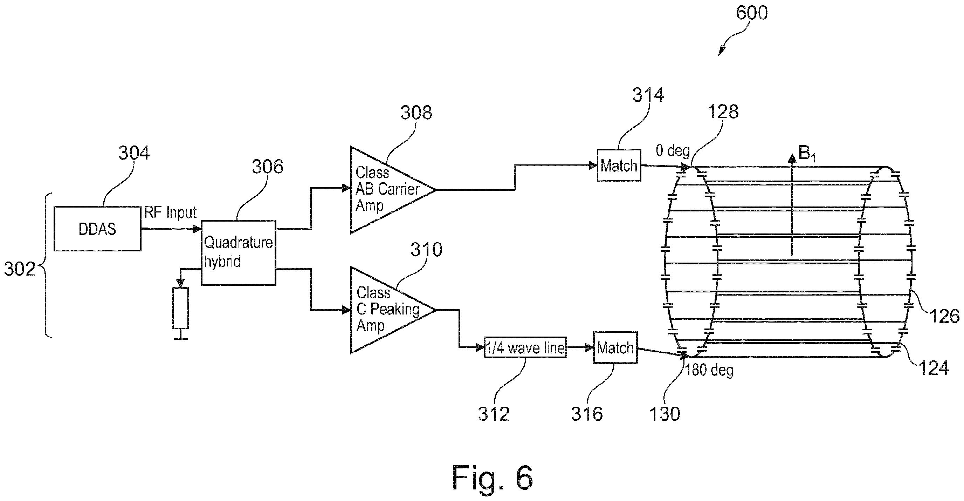

Correct driving can also be realized by locating the quarter wave inverter behind the peaking amplifier. Fig. 6 shows a further example of a radio-frequency system 600. The radio-frequency system 600 of Fig. 6 is similar to the radio-frequency system 500 of Fig. 5. In the example in Fig. 6 the quarter wave line delay 312 has been removed and the first carrier amplifier 308 is connected directly to the first matching network 314. The half wave line delay has been removed and replaced with a quarter wave line delay 312. The second peaking amplifier 310 is then connected to the second matching network 316 with the quarter wave line delay 312. The remainder of the implementation shown in Fig. 6 is identical with the implementation in Fig. 5.

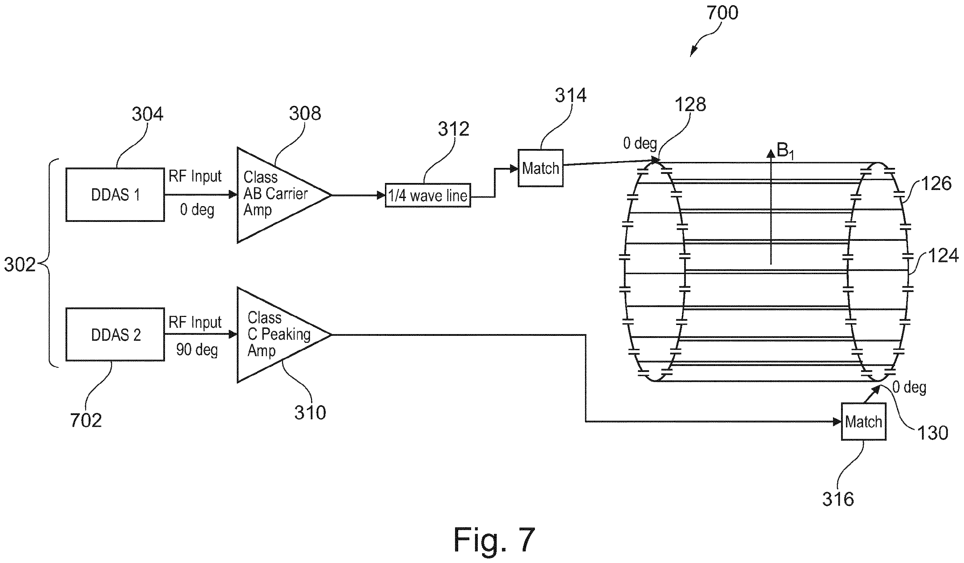

Figs.7-and 8 show a digital RF chain using Body Coil combination of Doherty RF amplifier. Individual RF amplifiers are fed by individual digital transmitters.

The Doherty principle does not necessarily require the feeding of the Doherty submodules via a single RF input and a Quadrature hybrid. When properly synchronized, each module may be driven by an individual DA converter (DDAS x). Fig. 7 illustrates a further example of a radio-frequency system 700. The radio-frequency system 700 shown in Fig. 7 is similar to the radio-frequency system 300 in Fig. 3. In the example in Fig. 7, the quadrature hybrid has been removed and instead a second digitally controlled transmitter 702 is used. The first digitally controlled transmitter 304 is connected directly to the first carrier amplifier 308. The second digitally controlled transmitter 702 is connected directly to the first peaking amplifier 310.

Because the digitally controlled transmitters 304, 702 can have their amplitude and phase controlled directly the RF input to the first peaking amplifier is shifted by 90° with respect to the first carrier amplifier. The output of the first carrier amplifier 308 is connected to the quarter wave line 312 as is illustrated in Fig. 3. The output of the first peaking amplifier 310 is connected to the second matching network 316 as is also illustrated in Fig. 3. The remainder of the circuitry is identical as it is shown in Fig. 3.

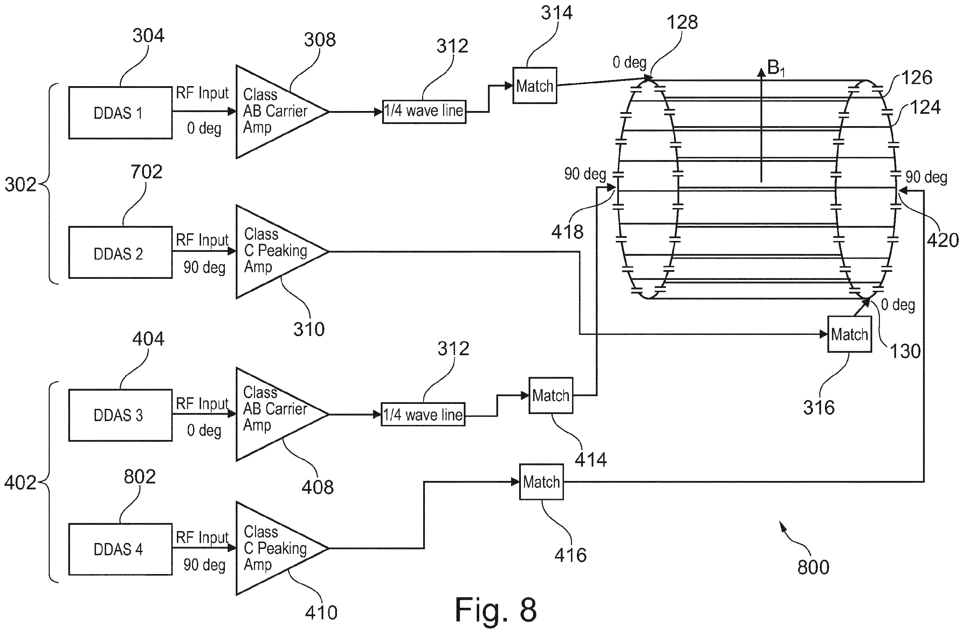

Fig. 8 shows a further example of a radio-frequency system 800. The radio-frequency system 800 of Fig. 8 is similar to the radio-frequency system 400 of Fig. 4. In Fig. 8 the quadrature hybrids have been removed and each amplifier 308, 310, 408, 410 receives input directly from a digitally controlled transmitter. Again, in Fig. 8 there is a first Doherty amplifier 302 and a second Doherty amplifier 402. The first Doherty amplifier 302 is as illustrated as the first Doherty amplifier 302 in Fig. 7. The second Doherty amplifier 402 comprises a third digitally controlled transmitter that is directly connected to the second carrier amplifier 408.

There is a fourth digitally controlled transmitter 804 that is directly connected to the second peaking amplifier 410. The input of the second peaking amplifier is shifted by 90° with respect to the input of the second carrier amplifier 408. The output of the second carrier amplifier is connected to the quarter wave line 312 and the output of the second peaking amplifier 410 is connected to the fourth matching network 416. The remainder of the circuit of the second Doherty amplifier 402 is identical as is illustrated in Fig. 4.

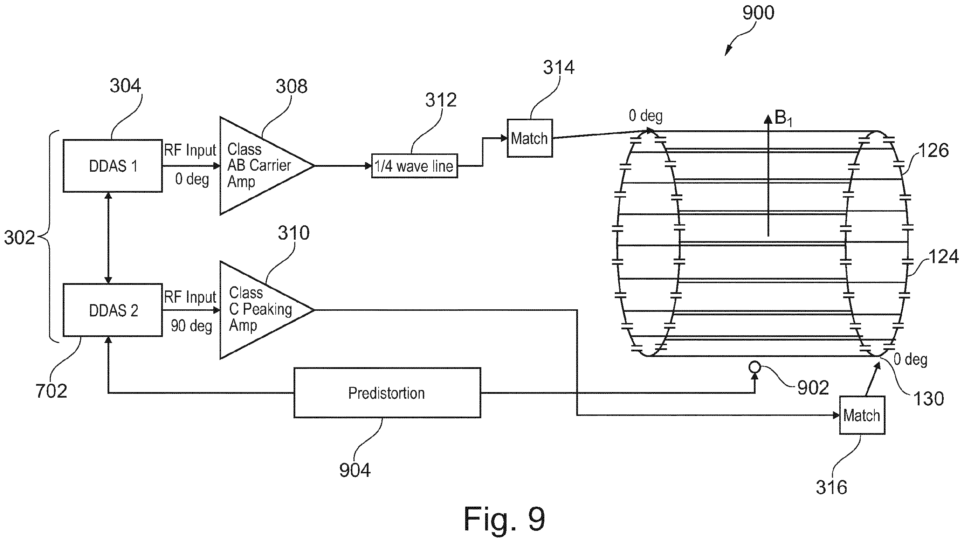

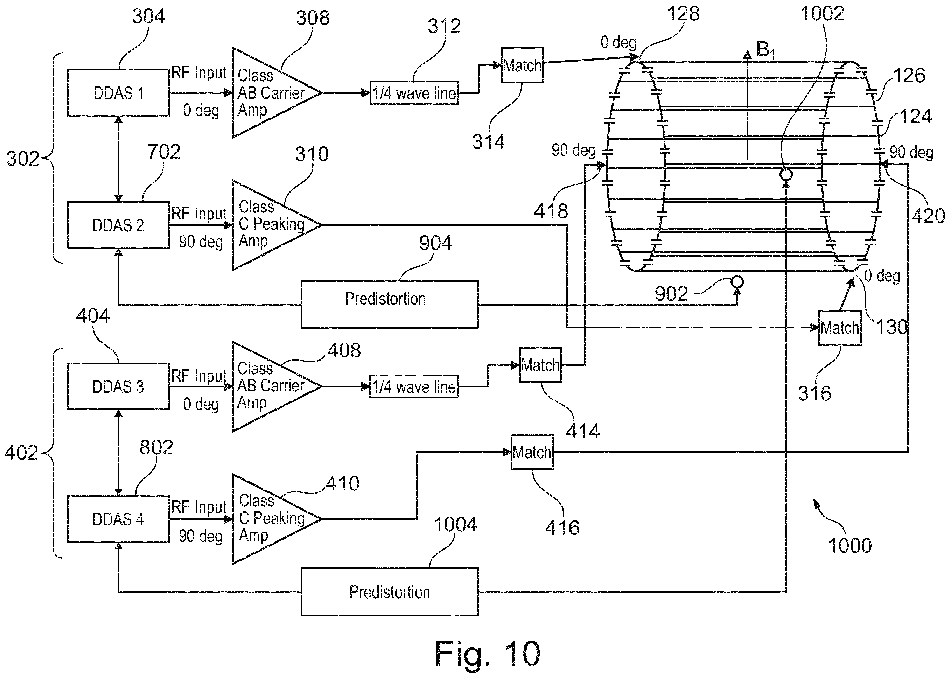

Fig.9 and 10 show a Digital RF chain using Body Coil combination of Doherty RF amplifiers. The feeding and parameter setting of the individual RF amplifiers is controlled by a digital feedback loop. Modifying the TX chain in the way shown in Figs.7 and 8 extends the options to further enhance the signal purity (e.g. the transition state where the class C module is about to be turned on) and efficiency control. Methods like pre-distortion and or digital feedback can be applied based on a comparison of the demand signal with the actual fields in the body coil and the operation mode parameters of the individual modules.

Fig. 9 illustrates a further example of a radio-frequency system 900. The radio-frequency system 900 in Fig. 9 is a modification of the radio-frequency system 700 of Fig. 7. The radio-frequency system 900 of Fig. 9 additionally comprises a first magnetic field sensor 902 that records magnetic field data which it sends to a first controller 904. The first controller 904 is then configured to control the first digitally controlled transmitter 304 and the second digitally controlled transmitter 702. Depending upon the measurement of the magnetic field by the first magnetic field sensor 902 the first controller 904 can adjust the phase and/or amplitude that are output by the first digitally controlled transmitter 304 and the second digitally controlled transmitter 702. This enables better linearization of the first Doherty amplifier 302.

Fig. 10 shows a further example of a radio-frequency system 1000. The radio-frequency system 1000 of Fig. 10 is a modification of the radio-frequency system 800 of Fig. 8. The first Doherty amplifier 302 is identical with the first Doherty amplifier 302 of Fig. 9. The second Doherty amplifier 402 has been modified in an equivalent way. The radio-frequency system 1000 is shown as comprising a second magnetic field sensor 1002. The second magnetic field sensor 1002 is mounted at quadrature so that it measures a different mode than the first magnetic field sensor 902.

The second magnetic field sensor 1002 is shown as being connected to a second controller 1004. The second controller 1004 takes measurements from the second magnetic field sensor 1002 and uses these to control and adjust the third digitally controlled transmitter 404 and the fourth digitally controlled transmitter 802. In this way the second Doherty amplifier 402 is made more linear than the first Doherty amplifier 302 was.

It should be noted that the first controller 904 and the second controller 1004 could be implemented by a single control device.

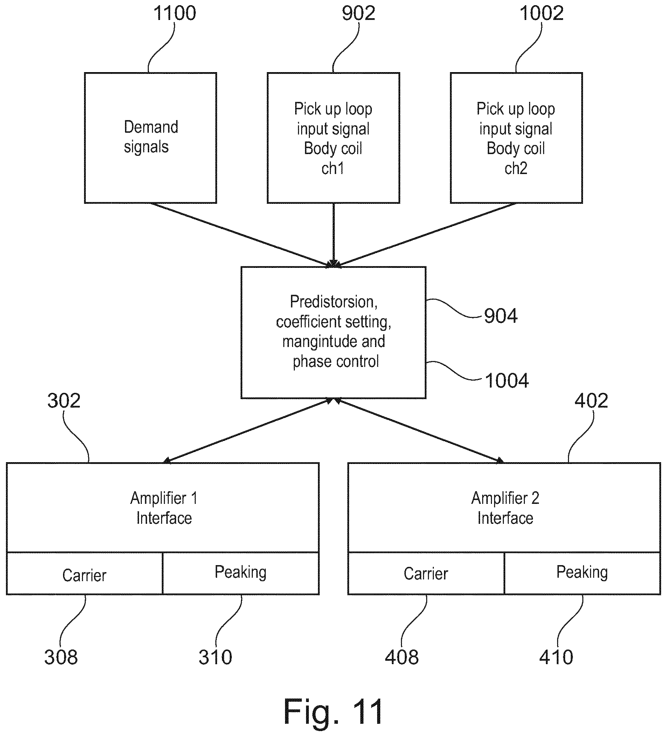

Fig.11 shows a software plan and algorithm for digital RF chain using body coil combiner Doherty concept. A digital feedback loop and software program controls the feeding, balancing, calibration and parameter setting of the individual RF amplifiers. Fig. 11 shows the software plan and algorithm for realizing the extended control. The information flow between amplifiers and central control unit is bi-directional since amplifier status information (temperatures, power supply status, actual bias...) may be used for the feedback.

Fig. 11 illustrates a software plan and algorithm for the first controller 904 and second controller 1004 of Figs. 9 or 10. The algorithm shows a box which represents the demand of signals 1100. This results in the first magnetic field sensor 902 providing an input signal as a first channel. The second magnetic field sensor 1002 provides a signal on a second channel. These are all then fed to the pre-distortion system which is the first controller 904 and the second controller 1004. This has algorithms which relay the input from 902 and 1002 into coefficient setting for controlling the phase and magnitude control. Signals are then provided to the first Doherty amplifier 302 and the second Doherty amplifier 402 via an interface. This is then used to control the individual digitally controlled transmitters to adjust the carrier amplifiers 308, 408 and the peaking amplifiers 310, 410.

The Doherty principle is not restricted to two amplifier sub modules. Depending on output power ranges, linearity demands and costs more submodules may be employed to reach the desired cost effective performance.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS

- 100: magnetic resonance imaging system
- 102: magnet assembly
- 104: magnet
- 106: bore of magnet
- 108: imaging zone
- 109: region of interest
- 110: magnetic field gradient coils
- 112: magnetic field gradient coil power supply
- 114: receive coil
- 116: receiver
- 118: subject
- 120: subject support
- 122: doherty amplifier
- 122': 3-way doherty amplifier
- 123: radio frequency system
- 124: radio frequency antenna
- 126: power combiner
- 128: first connection port
- 130: second connection port
- 140: computer system
- 142: hardware interface
- 144: processor
- 146: user interface
- 148: computer memory
- 150: machine executable instructions
- 152: pulse sequence commands
- 154: magnetic resonance data
- 156: magnetic resonance image
- 200: magnetic resonance imaging system
- 202: additional connection port
- 300: radio frequency system
- 302: first doherty amplifier
- 304: first digitally controlled transmitter
- 306: quadrature hybrid
- 308: first carrier amplifier
- 310: first peaking amplifier
- 312: 1/4 wave line delay
- 314: first matching network
- 316: second matching network
- 400: radio frequency system
- 402: second doherty amplifier
- 404: third digitally controlled transmitter
- 408: second carrier amplifier
- 410: second peaking amplifier
- 414: third matching network
- 416: fourth matching network
- 418: third connection port
- 420: fourth connection port
- 500: radio frequency system
- 502: 1/2 wave line delay
- 600: radio frequency system
- 700: radio frequency system
- 702: second digitally controlled transmitter
- 800: radio frequency system
- 802: fourth digitally controlled transmitter
- 900: radio frequency system
- 902: first magentic field sensor
- 904: first controller
- 1000: radio frequency system
- 1002: second magentic field sensor
- 1004: second controller

## Claims

1. A radiofrequency system (123, 300, 400, 500, 600, 700, 800, 900, 1000) for a magnetic resonance imaging system (100, 200), wherein the radiofrequency system comprises a first Doherty amplifier (302) and a radio frequency antenna (124), wherein the first Doherty amplifier comprises a first carrier amplifier (308) and a first peaking amplifier (310), wherein the radio frequency antenna is tuned to a magnetic resonance frequency, wherein the first carrier amplifier is connected to the radio frequency antenna at a first connection port (128) of the radio frequency antenna, wherein the first peaking amplifier is connected to the radio frequency antenna at a second connection port (130) of the radio frequency antenna, wherein the first Doherty amplifier is configured for supplying first Radio Frequency power at the magnetic resonance frequency, and wherein the radio frequency antenna is configured as a power combiner (126) of the first Doherty amplifier.

2. The radio frequency system of claim 1, wherein the first carrier amplifier is connected to the first connection port via a first matching network (314), wherein the first peaking amplifier is connected to the second connection port via a second matching network (316).

3. The radio frequency system of claim 1 or 2, wherein the first carrier amplifier is driven by a first digitally controlled transmitter (304), wherein the first peaking amplifier is driven by a second digitally controlled transmitter (702).

4. The radio frequency system of claim 3, wherein the radio frequency system comprises a first magnetic field sensor (902) for measuring first magnetic field data descriptive of a first B1 magnetic field generated by the first Doherty amplifier and the radio frequency coil; wherein the radio frequency system further comprises a first controller (904) configured for controlling the first digitally controlled transmitter; wherein the first controller is further configured for receiving the first magnetic field data from the first magnetic field sensor; wherein the controller is further configured to adjust the output of the the first digitally controlled transmitter and the second digitally controlled transmitter using the first magnetic field data to linearize the first Doherty amplifier.

5. The radio frequency system of any one of claims 1 to 4, wherein the first carrier amplifier is a class AB amplifier, and wherein the first peaking amplifier is a class C amplifier.

6. The radiofrequency system of any one of claims 1 through 5, wherein the radiofrequency system further comprises a second Doherty amplifier (402), wherein the second Doherty amplifier comprises a second carrier amplifier (408) and a second peaking amplifier (410), wherein the second carrier amplifier is connected to the radio frequency antenna at a third connection port (418) of the radio frequency antenna, wherein the second carrier amplifier is connected to the radio frequency antenna at a fourth connection port (420) of the radio frequency antenna, wherein the second Doherty amplifier is configured for supplying second Radio Frequency power at the magnetic resonance frequency, wherein the second Doherty amplifier is configured for supplying the second Radio Frequency power to the third connection port in quadrature to the first Radio Frequency power supplied to the first connection port and the second connection port, and wherein the radio frequency antenna is further configured as the power combiner (126) of the second Doherty amplifier.

7. The radio frequency system of claim 6, wherein the second carrier amplifier is connected to the third connection port via a third matching network (414), wherein the second peaking amplifier is connected to the fourth connection port via a fourth matching network (416).

8. The radio frequency system of claim 6 or 7, wherein the first connection port and the second connection port are in phase at the magnetic resonance frequency, wherein at the magnetic resonance frequency the third connection port and the fourth connection port are in phase, wherein at the magnetic resonance frequency the third connection port is at quadrature to the first connection port and the second connection port.

9. The radio frequency system of claim 6 through 8, wherein the second carrier amplifier is driven by a third digitally controlled transmitter (404), and wherein the second peaking amplifier is driven by a fourth digitally controlled transmitter (802).

10. The radio frequency system of claim 9, wherein the radio frequency system comprises a second magnetic field sensor (1002) for measuring second magnetic field data descriptive of a second B1 magnetic field generated by the second Doherty amplifier and the radio frequency coil; wherein the radio frequency system further comprises a second controller (1004) configured for controlling the third digitally controlled transmitter and the fourth digitally controlled transmitter; wherein the second controller is further configured for receiving the second magnetic field data from the second magnetic field sensor; and wherein the second controller is further configured to adjust the output of the third digitally controlled transmitter and the fourth digitally controlled transmitter using the second magnetic field data to linearize the second Doherty transmitter.

11. The radio frequency system of any one of claims 6 through 10, wherein the second carrier amplifier is a class AB amplifier, and wherein the second peaking amplifier is a class C amplifier.

12. The radio frequency system of any one of the preceding claims, wherein the radio frequency coil is a birdcage coil, a TEM coil, an array of cylindrical birdcage coils, a surface loop coil, a body coil, a head coil, and a solenoidal coil.

13. The radio frequency system of claim 1 or 2, wherein the first Doherty amplifier is a 3-way Doherty amplifier (122'), wherein the first Doherty amplifier further comprises an additional peaking amplifier, wherein the additional peaking amplifier is connected to the radio frequency antenna at an additional connection port (202) of the radio frequency antenna, wherein the first Doherty amplifier is configured for supplying the Radio Frequency power to the first connection port, the second connection port, and the first additional connection port in phase.

14. A magnetic resonance magnet assembly (102) comprising:
- a main magnet (104) for generating a main magnetic field; and
- a radio frequency system (123, 300, 400, 500, 600, 700, 800, 900, 1000) according to any one of claims 1 through 13.

15. A magnetic resonance imaging system (100, 200) for acquiring magnetic resonance data from an imaging zone (108), wherein the magnetic resonance imaging system comprises the magnetic resonance magnet assembly (102) of claim 14.
